# EUROPEAN PATENT SPECIFICATION

(11) **EP 2 825 689 B1**
(45) Date of publication and mention of the grant of the patent: **18.05.2016**
(21) Application number: 13709443.9
(22) Date of filing: 15.03.2013
(51) Int. Cl.: C23C 18/22

(54) **PROCESS FOR METALLIZING NONCONDUCTIVE PLASTIC SURFACES**
VERFAHREN ZUM METALLISIEREN NICHTLEITENDER KUNSTSTOFFOBERFLÄCHEN
PROCÉDÉ DE MÉTALLISATION DE SURFACES EN MATIÈRE SYNTHÉTIQUE NON CONDUCTRICES

(30) Priority: 15.03.2012 EP 12159654
(43) Date of publication of application: 21.01.2015
(73) Proprietor: Atotech Deutschland GmbH, 10553 Berlin (DE)
(72) Inventor: MIDDEKE, Hermann, 14612 Falkensee (DE); KUHMEISER, Enrico, 12524 Berlin (DE); SCHNEIDER, Steve, 13189 Berlin (DE)
(74) Representative: Wonnemann, Jörg
(86) International application number: PCT/EP2013/055358
(87) International publication number: WO 2013/135864

(56) References cited:
- EP-A1- 2 025 708
- US-A- 5 160 600

## Description

### Field of the invention

The present invention relates to a process for metallizing electrically nonconductive plastic surfaces of articles using an etching solution free of hexavalent chromium. The etching solution is based on a permanganate solution. After the treatment with the etching solution, the articles can be metallized by means of known processes.

### Background of the invention

Articles made from electrically nonconductive plastic can be metallized by an electroless metallization process. In this process, the article is first cleaned and etched, then treated with a noble metal and finally metallized. The etching is typically undertaken by means of chromosulphuric acid. The etching serves to make the surface of the article receptive to the subsequent metallization, such that the surfaces of the articles are well-wetted with the respective solutions in the subsequent treatment steps and the deposited metal ultimately has sufficiently firm adhesion on the surface.

For etching, the surface of articles, for example made from acrylonitrile-butadiene-styrene copolymer (ABS copolymer), is etched using chromosulphuric acid, so as to form surface microcaverns in which metal is deposited and subsequently adheres there firmly. After the etching, the plastic is activated for the electroless metallization by means of an activator comprising a noble metal, and then metallized electrolessly. Subsequently, a thicker metal layer can also be applied electrolytically.

Etching solutions based on chromosulphuric acid, however, are toxic and should therefore be replaced as possible.

The literature describes attempts to replace etching solutions based on chromosulphuric acid with those comprising permanganate salts.
The use of permanganates in an alkaline medium for metallization of circuit boards as a carrier of electronic circuits has long been established. Since the hexavalent state (manganate) which arises in the oxidation is water-soluble and has sufficient stability under alkaline conditions, the manganate, similarly to trivalent chromium, can be oxidized electrolytically back to the original oxidizing agent, in this case the permanganate. The document DE 196 11 137 A1 describes the use of the permanganate also for metallization of other plastics as circuit board material. For the metallization of ABS plastics, a solution of alkaline permanganate has been found to be unsuitable since it was not possible in this way to obtain a reliable, sufficient adhesion strength between metal layer and plastic substrate. This adhesion strength is determined in the "peel test". It should have at least a value of 0.4 N/mm.

EP 1 0010 52 discloses an acidic permanganate solution which is said to be suitable for use in plastic galvanization. The solutions described therein differ in several respects from the present invention, for example because they use very high acid concentrations and very low permanganate concentrations (e.g. 15 M H₂SO₄ and 0.05 M KMnO₄). EP 1 0010 52 does not report the adhesion strengths achievable by this pretreatment. In-house experiments have shown that the adhesion strengths are below a value of 0.4 N/mm. Moreover, the solutions described in EP 1 0010 52 are unstable. A constant quality of the metallization therefore cannot be achieved.

As an alternative to chromosulphuric acid, WO 2009/023628 A2 proposes strongly acidic solutions comprising an alkali metal permanganate salt. The solution contains about 20 g/l alkali metal permanganate salt in 40 - 85% by weight phosphoric acid. Such solutions form colloidal manganese(IV) species which are difficult to remove. According to WO 2009/023628 A2, the effect of the colloids even after a short time is that coating of adequate quality is no longer possible. To solve the problem, WO 2009/023628 A2 proposes using manganese(VII) sources which do not contain any alkali metal or alkaline earth metal ions. However, the preparation of such manganese(VII) sources is costly and inconvenient.

Therefore, toxic chromosulphuric acid is still being used for etching treatment of plastics.

For industrial scale application of metallization of plastic surfaces, the articles are usually fastened to racks. These are metal carrier systems which allow the simultaneous treatment of a large number of articles with the successive solutions for the individual process steps, and last steps for electrolytic deposition of one or more metal layers. The racks are generally themselves coated with plastic. Therefore, the racks in principle likewise constitute a substrate for metallization processes on plastic surfaces.

However, the additional metallization of the racks is undesirable, since the metal layers have to be removed again from the racks after the coating of the articles. This means additional cost and inconvenience for the removal, combined with additional consumption of chemicals. Moreover, the productivity of the metallization plant in this case is lower, since the racks first have to be demetallized prior to reloading with articles.

In the case of use of chromic acid-containing etchants, this problem is much reduced. During the etching, chromic acid also penetrates into the plastic casing of the racks and diffuses back out of it during the subsequent process steps, thus preventing metallization of the rack.

Thus, if the intention is to replace toxic chromosulphuric acid for etching treatment of plastics with environmentally safe process steps, it is also advantageous to prevent unwanted metallization of the racks.

Patent DE 195 10 855 C2 describes a process for selective or partial electrolytic metallization of nonconductive materials. In this case, the simultaneous metallization of the racks is prevented by omitting treatment steps with adsorption-promoting solutions, called conditioners. However, it is emphasized that the process for metallizing nonconductive materials in DE 195 10 855 C2 is suitable only for direct metallization.

### Description of the drawings

- Figure 1:: Influence of the treatment time with etching solution on adhesion strength.
- Figure 2:: Influence of the treatment time of articles made from an ABS/PC mixture with glycol compounds on adhesion strength.
- Figure 3:: Influence of the treatment time of articles made from ABS with glycol compounds on adhesion strength.
- Figure 4:: Relationship between amount of manganese dioxide deposited on plastic surfaces and amount of palladium bound later to the plastic surfaces during process step B) when the manganese dioxide deposited has been removed from the plastic surfaces in the meantime in process step A i).

### Description of the invention

The present invention is therefore based on the problem that it has not been possible to date to achieve metallization of articles made from electrically nonconductive plastic in an environmentally safe manner with sufficient process reliability and adhesion strength of the metal layers applied subsequently.

It is therefore an object of the present invention to find etching solutions for electrically nonconductive plastic surfaces of articles, these being non-toxic but providing sufficient adhesion strength of the metal layers applied on the plastic surface.

This object is achieved by the following process according to the invention:
Process for metallizing electrically nonconductive plastic surfaces of articles, comprising the process steps of:
   A) etching the plastic surface with an etching solution;
   B) treating the plastic surface with a solution of a metal colloid or of a compound of a metal, the metal being selected from the metals of transition group I of the Periodic Table of the Elements and transition group VIII of the Periodic Table of the Elements, and
   C) metallizing the plastic surface with a metallizing solution;
   characterized in that the etching solution comprises a source for permanganate ions, and an acid in a concentration of 0.02 - 0.6 mol/l based on a monobasic acid.

Articles in the context of this invention are understood to mean articles which have been manufactured from at least one electrically nonconductive plastic or which have been covered with at least one layer of at least one electrically nonconductive plastic. The articles thus have surfaces of at least one electrically nonconductive plastic. Plastic surfaces are understood in the context of this invention to mean these said surfaces of the articles.

The process steps of the present invention are performed in the sequence specified, but not necessarily in immediate succession. It is possible for further process steps and additionally rinse steps in each case, preferably with water, to be performed between the steps.

The inventive etching of the plastic surface with an etching solution comprising a source for permanganate ions (process step A)) achieves higher adhesion strengths of the metal layer or metal layers to be applied to the plastic surfaces than by the treatments already known, for example with chromosulphuric acid. For the inventive etching, an etching solution having a low acid concentration and a high permanganate concentration is used. This allows the formation of manganese dioxide species to be adjusted such that the stability of the etching solution is ensured and an excellent adhesion strength is nevertheless achieved. The adhesion strength achieved by the inventive etching is also much higher than with known etching processes based on alkaline permanganate solutions or etching solutions with high acid concentration and low permanganate concentration.

The plastic surfaces have been manufactured from at least one electrically nonconductive plastic. In one embodiment of the present invention, the at least one electrically nonconductive plastic is selected from the group comprising an acrylonitrile-butadiene-styrene copolymer (ABS copolymer), a polyamide (PA), a polycarbonate (PC) and a mixture of an ABS copolymer with at least one further polymer.
In a preferred embodiment of the invention, the electrically nonconductive plastic is an ABS copolymer or a mixture of an ABS copolymer with at least one further polymer. The at least one further polymer is more preferably polycarbonate (PC), which means that particular preference is given to ABS/PC mixtures.

In one embodiment of the invention, process step A) may be preceded by performance of the following further process step:
treatment of the rack with a solution comprising a source for iodate ions.

The treatment of the rack with a solution comprising a source for iodate ions is also referred to hereinafter as protection of the rack. The protection of the rack can take place at various times during the process according to the invention.

At this time, the articles are not yet fastened to the rack. The rack is thus treated alone, without the articles, with the solution comprising a source for iodate ions.

In a further embodiment of the invention, process step A) may be preceded by performance of the following further process step:
fastening of the article or articles to a rack.

This further process step is referred to hereinafter as fastening step. The fastening of the articles to racks enables the simultaneous treatment of a large number of articles with the successive solutions for the individual process steps, and the establishment of electrical contact connection during the last steps for electrolytic deposition of one or more metal layers. The treatment of the articles by the process according to the invention is preferably performed in a conventional dipping process, by dipping the articles successively into solutions in vessels in which the respective treatment takes place. In this case, the articles may be dipped into the solutions either fastened to racks or accommodated in drums. Fastening to racks is preferred. The racks are generally themselves coated with plastic. The plastic is usually polyvinyl chloride (PVC).

In a further embodiment of the invention, the protection of the rack can be performed prior to the fastening step.

In a preferred embodiment of the invention, process step A) is preceded by performance of the following further process step:
treating the plastic surface in an aqueous solution comprising at least one glycol compound.

This further process step is referred to hereinafter as pretreatment step. This pretreatment step increases the adhesion strength between the plastic and the metal layer.

If process step A) has additionally been preceded by performance of the fastening step, the pretreatment step is performed between the fastening step and process step A).

A glycol compound is understood to mean compounds of the following general formula (I): 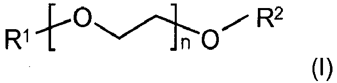 wherein
n is an integer from 1 to 4; and
R¹ and R² are each independently -H, -CH₃, -CH₂-CH₃, -CH₂-CH₂-CH₃, -CH(CH₃)-CH₃, -CH₂-CH₂-CH₂-CH₃, -CH(CH₃)-CH₂-CH₃, -CH₂-CH(CH₃)-CH₃, -CH₂-CH₂-CH₂-CH₂-CH₃, -CH(CH₃)-CH₂-CH₂-CH₃, -CH₂-CH(CH₃)-CH₂-CH₃, -CH₂-CH₂-CH(CH₃)-CH₃, -CH(CH₂-CH₃)-CH₂-CH₃, -CH₂-CH(CH₂-CH₃)-CH₃, -CO-CH₃, -CO-CH₂-CH₃, -CO-CH₂-CH₂-CH₃, -CO-CH(CH₃)-CH₃, -CO-CH(CH₃)-CH₂-CH₃, -CO-CH₂-CH(CH₃)-CH₃, -CO-CH₂-CH₂-CH₂-CH₃.

According to the general formula (I), the glycol compounds include the glycols themselves and glycol derivatives. The glycol derivatives include the glycol ethers, the glycol esters and the glycol ether esters. The glycol compounds are solvents.

Preferred glycol compounds are ethylene glycol, diethylene glycol, ethylene glycol monomethyl ether acetate, ethylene glycol monoethyl ether acetate, ethylene glycol monopropyl ether acetate, ethylene glycol acetate, diethylene glycol monoethyl ether acetate, diethylene glycol monomethyl ether acetate, diethylene glycol monopropyl ether acetate, butyl glycol, ethylene glycol monobutyl ether, ethylene glycol diacetate and mixtures thereof. Particular preference is given to diethylene glycol monoethyl ether acetate, ethylene glycol acetate, ethylene glycol diacetate, butyl glycol and mixtures thereof.

In the case of use of glycol esters and glycol ether esters, it is advisable to keep the pH of the aqueous solution of the glycol compound within the neutral range by suitable measures, in order to as far as possible suppress the hydrolysis to give the alcohol and carboxylic acid. One example is the hydrolysis of the diethylene glycol monoethyl ether acetate:

CH₃-CO-O-CH₂CH₂-O-CH₂CH₂-O-CH₂CH₃ + H₂O → CH₃-COOH + HO-CH₂CH₂-O-CH₂CH₂-O-CH₂CH₃

The water concentration of the solution comprising a glycol compound likewise has an influence on the hydrolysis of the glycol esters and glycol ether esters. However, the solution has to contain water for two reasons: firstly to obtain a noncombustible treatment solution and secondly to be able to adjust the strength of the attack on the plastic surface. A pure solvent, i.e. 100% of a glycol compound, would dissolve most uncrosslinked polymers or at least leave an unacceptable surface. It has therefore been found to be very advantageous to buffer the solution of a glycol ester or glycol ether ester and thus to keep it within the neutral pH range, which means scavenging the protons obtained by hydrolysis of the solvent. A phosphate buffer mixture has been found to be sufficiently suitable for this purpose. The readily soluble potassium phosphates allow sufficiently high concentrations with good buffer capacity at solvent concentrations up to 40% by vol.

The optimal treatment time for the plastic surface depends on the plastic used, the temperature, and the nature and concentration of the glycol compound. The treatment parameters have an influence on the adhesion between the treated plastic surface and the metal layer applied in downstream process steps. Higher temperatures or concentrations of the glycol compounds also influence the texture of the plastic surface. In any case, it should be possible for the downstream etching step A) to remove the solvent from the plastic matrix again, because the subsequent steps in the process, more particularly the activation in process step B), are otherwise disrupted.

The process according to the invention gives adhesion strengths of at least 0.8 N/mm, which is well above the required minimum value of 0.4 N/mm. The treatment time in the pretreatment step is between 1 and 30 minutes, preferably between 5 and 20 minutes and more preferably between 7 and 15 minutes.

The treatment temperature is between 20°C and 70°C, depending on the nature of the solvent or solvent mixture used. Preference is given to a treatment temperature between 20°C and 50°C, particular preference to a treatment temperature between 20°C and 45°C.

The treatment of the plastic surfaces in the pretreatment step can be performed in an aqueous solution comprising one glycol compound or in an aqueous solution comprising two or more different glycol compounds. The total concentration of glycol compounds in the aqueous solution is 5% by vol. - 50% by vol., preferably 10% by vol. - 40% by vol. and more preferably 20% by vol. - 40% by vol. If said solution contains one glycol compound, the overall concentration corresponds to the concentration of this one glycol compound. If said solution contains two or more different glycol compounds, the total concentration corresponds to the sum total of the concentrations of all glycol compounds present. In the context of the solution containing at least one glycol compound, the concentration figures for the glycol compound/glycol compounds in % are always understood to mean a concentration in % by vol.

For instance, for pretreatment of ABS plastic surfaces, a solution of 15% by vol. of diethylene glycol monoethyl ether acetate in a mixture with 10% by vol. of butyl glycol at 45°C has been found to be advantageous (see Example 1). The first solvent therein serves to generate the adhesion strength, while the second, as a nonionic surfactant, increases wettability and helps to remove any soiling present from the plastic surface.

For pretreatment of ABS/PC mixtures, for example Bayblend T45 or Bayblend T65PG, a solution of 40% by vol. of diethylene glycol monoethyl ether acetate in water at room temperature has been found to be more advantageous, because it allows a higher adhesion strength of the metal layers applied in the case of these plastics (see Example 2).

In a further embodiment of the invention, the protection of the rack can be performed between the fastening step and the pretreatment step.

In a further embodiment of the invention, the protection of the rack can be performed between the pretreatment step and process step A).

At these times, the articles have already been fastened to the rack. The rack is thus treated together with the articles with the solution comprising a source for iodate ions. The wordings "the rack is treated with a solution comprising a source for iodate ions" and "treatment of the rack with a solution comprising a source for iodate ions" in the context of this invention mean that the protection of the rack can take place alone, without the articles (for example when the protection of the rack takes place prior to the fastening step), or that the protection of the rack can take place together with the articles (for example when the protection of the rack takes place at some time after the fastening step).

Irrespective of whether the protection of the rack takes place alone or together with the articles, it leads to protection of the plastic casing of the racks against metal deposition while the articles which are fastened to the racks during the fastening step are being metallized. The protection of the rack ensures that the plastic casing of the racks is not metallized in the later process steps B) to C), meaning that the racks remain free of metal. This effect is particularly pronounced on a PVC casing of the racks.

The inventive etching treatment in process step A) is performed in an etching solution comprising a source for permanganate ions. The source for permanganate ions is selected from alkali metal permanganates. The alkali metal permanganates are selected from the group comprising potassium permanganate and sodium permanganate. The source for permanganate ions is present in the etching solution in a concentration between 30 g/l and 250 g/l, preferably between 30 g/l and 180 g/l, further preferably between 90 g/l and 180 g/l, more preferably between 90 g/l and 110 g/l and even more preferably between 70 g/l and 100 g/l. Owing to its solubility, potassium permanganate may be present in the etching solution in a concentration of up to 70 g/l. Sodium permanganate may be present in the etching solution in a concentration of up to 250 g/l. The lower concentration limit for each of these two salts is typically 30 g/l. The content of sodium permanganate is preferably between 90 g/l and 180 g/l.

The etching solution is acidic, meaning that it contains an acid. Surprisingly, alkaline permanganate solutions, as used routinely in the circuit board industry as an etching solution, are unsuitable for the present invention, since they do not give sufficient adhesion strength between plastic surface and metal layer.

Acids which are used in the etching solution are preferably inorganic acids. The inorganic acid in the etching solution in process step A) is selected from the group comprising sulphuric acid, nitric acid and phosphoric acid. The acid concentration must not be too high, since the etching solution is otherwise not stable. The acid concentration is between 0.02 - 0.6 mol/l based on a monobasic acid. It is preferably between 0.06 and 0.45 mol/l, more preferably between 0.07 and 0.30 mol/l, based in each case on a monobasic acid. Preference is given to using sulphuric acid in a concentration between 0.035 and 0.15 mol/l, corresponding to an acid concentration between 0.07 and 0.30 mol/l based on a monobasic acid.

In a further embodiment the etching solution does only contain a source for permanganate ions as described above and an acid as described above. In this embodiment the etching solution does not contain any further ingredients.

The etching solution can be employed at temperatures between 30°C and 90°C, preferably between 55°C and 75°C. It has been found that sufficiently high adhesion strengths between metal layers and plastic surfaces can also be achieved at low temperatures between 30°C and 55°C. In that case, however, it is not possible to ensure that all solvent from the treatment with glycol compound in the pretreatment step has been removed from the plastic surface. This is particularly true of pure ABS. Thus, if the pretreatment step in the process according to the invention is executed, the temperatures in the downstream process step A) should be selected at a higher level, namely within the range from 55°C to 90°C, preferably within the range from 55°C to 75°C. The optimal treatment time depends on the plastic surface being treated and the selected temperature of the etching solution. For ABS and ABS/PC plastic surfaces, the best adhesion strength between plastic surface and subsequently applied metal layer is achieved at a treatment time between 5 and 30 minutes, preferably between 10 and 25 minutes and more preferably between 10 and 15 minutes. A longer treatment time than 30 minutes generally leads to no further improvement in the adhesion strengths.

An acidic permanganate solution is very reactive at elevated temperatures, for example at 70°C. The oxidation reaction with the plastic surface then forms many manganese(IV) species which precipitate out. These manganese(IV) species are predominantly manganese(IV) oxides or oxide hydrates and are referred to hereinafter simply as manganese dioxide.

The manganese dioxide precipitate has a disruptive effect on the subsequent metallization if it remains on the plastic surface. During the activation in process step B), it ensures that regions of the plastic surface are not covered with metal colloid or gives rise to unacceptable roughness of the metal layer to be applied in later process steps.

The manganese dioxide also catalyses the reaction of the permanganate with water and can thus lead to instability of the etching solution. The etching solution should therefore advantageously be kept free of manganese dioxide. It has been found that, surprisingly, the formation of manganese dioxide species which are difficult to remove is noticeably decreased when the acid concentration selected in the etching solution is low and the permanganate concentration selected is high.

Regular, generally daily, analysis for constituents of the etching solution is advantageous in order to optimize process reliability. This includes the titration of the acid to obtain the original acid concentration, and the photometric determination of the permanganate concentration. The latter can be effected with a simple photometer. The light from green light-emitting diodes (wavelength λ = 520 nm) corresponds quite accurately to the absorption maximum of permanganate. The consumptions then have to be replaced according to the analytical data. Experiments have shown that, at the operating temperature recommended for process step A), within a reaction time of 10 minutes, about 0.7 g/m² to 1.2 g/m² of manganese dioxide forms on the surface of ABS plastics. Compared to the losses resulting from drag-out of permanganate solution by the articles, this consumption in the surface reaction is negligible.

The inventive etching solution does not contain any chromium or chromium compounds; the etching solution contains neither chromium(III) ions nor chromium(VI) ions. The inventive etching solution is thus free of chromium or chromium compounds; the etching solution is free of chromium(III) ions and chromium(VI) ions.

In a further embodiment, the articles, after the permanganate treatment in process step A), are cleaned by rinsing off excess permanganate solution. The rinsing is effected in one or more, preferably three, rinsing steps with water.

In a further preferred embodiment of the invention, the following further process step is performed between process steps A) and B):
A i) treating the plastic surface in a solution comprising a reducing agent for manganese dioxide.

The further process step A i) is also referred to as reduction treatment. This reduction treatment reduces manganese dioxide adhering to the plastic surfaces to water-soluble manganese(II) ions. The reduction treatment is conducted after the permanganate treatment in process step A) and optionally after the rinsing. For this purpose, an acidic solution of a reducing agent is used. The reducing agent is selected from the group comprising hydroxylammonium sulphate, hydroxylammonium chloride and hydrogen peroxide. Preference is given to an acidic solution of hydrogen peroxide because hydrogen peroxide is neither toxic nor complex-forming. The content of hydrogen peroxide in the solution of the reduction treatment (reduction solution) is between 25 ml/l and 35 ml/l of a 30% hydrogen peroxide solution (% by weight), preferably 30 ml/l of a 30% hydrogen peroxide solution (% by weight).

The acid used in the reduction solution is an inorganic acid, preferably sulphuric acid. The acid concentration is 0.5 mol/l to 5.0 mol/l, preferably 1.0 mol/l to 3.0 mol/l, more preferably 1.0 mol/l to 2.0 mol/l, based in each case on a monobasic acid. In the case of use of sulphuric acid, particular preference is given to concentrations of 50 g/l 96% sulphuric acid to 100 g/l 96% sulphuric acid, corresponding to an acid concentration of 1.0 mol/l to 2.0 mol/l based on a monobasic acid.

The reduction treatment removes the manganese dioxide precipitate which disrupts the metallization of the articles. As a result, the reduction treatment of process step A i) promotes the homogeneous and continuous coverage of the articles with the desired metal layer and promotes the adhesion strength and smoothness of the metal layer applied to the articles.

The reduction treatment in process step A i) likewise has an advantageous effect on the metallization of the plastic casing of the rack. The unwanted coverage of the plastic casing with palladium during process step B) is suppressed. This effect is particularly pronounced when the reduction solution comprises a strong inorganic acid, preferably sulphuric acid. Hydrogen peroxide is preferred over hydroxylammonium sulphate or chloride in the reduction solution also because it better suppresses rack metallization.

The reduction treatment in process step A i) is performed at a temperature between 30°C and 50°C, preferably at 40°C to 45°C. The reduction treatment is performed for a period between 1 and 10 minutes, preferably between 3 and 6 minutes. In order to achieve sufficient protection of the racks prior to activation, it is advantageous to increase the treatment time in the reduction solution to 3 to 10 minutes, preferably to 3 to 6 minutes.

The hydrogen peroxide reducing agent used has to be replenished from time to time. The consumption of hydrogen peroxide can be calculated from the amount of manganese dioxide bound to the plastic surfaces. In practice, it is sufficient to observe the evolution of gas in the course of the reduction reaction during process step A i) and to meter in the original amount of hydrogen peroxide, for example 30 ml/l of a 30% solution, when the evolution of gas abates. At elevated operating temperature of the reduction solution, for example at 40°C, the reaction is rapid and is complete after one minute at most.

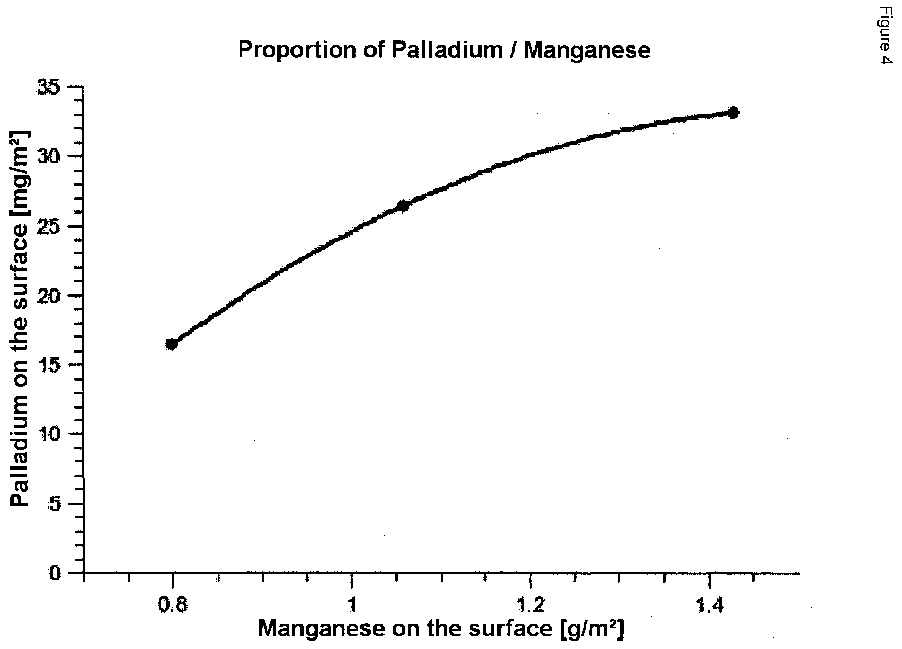

Moreover, it has been found that, surprisingly, in the case of deposition of an increasing amount of manganese dioxide on the plastic surface in process step A) (etching), the coverage of the plastic surface with metal colloid in the later activation (process step B)) increases when the deposited manganese dioxide is removed from the plastic surface in-between, in process step A i) (reduction treatment). This relationship is shown in Figure 4. As described in the section regarding process step A) (etching), higher concentrations of sulphuric acid in the etching solution lead to the advantageous deposition of an increasing amount of manganese dioxide on the plastic surface. At the same time, higher concentrations of sulphuric acid in the etching solution, however, also have the adverse effects that the increasing amount of manganese dioxide distinctly impairs the stability of the etching solution, and deposits of manganese dioxide have to be removed again to an increased extent from the plastic surface after the etching (process step A)). The level of the sulphuric acid concentration in the etching solution thus leads to opposing effects which have both positive and negative effects on the quality of the metal layer ultimately to be applied to the plastic surface. The concentration range of the inorganic acid specified in the section regarding process step A) (etching), and particularly that for sulphuric acid in the etching solution, is thus the concentration window within which the adverse effects are very substantially suppressed, while the advantageous effects are supported to the best possible extent.

In a further embodiment of the invention, the protection of the rack can be conducted between process step A) and process step B), preferably between process steps A i) and A ii).

Irrespective of the time of protection of the rack among the times described in the process according to the invention, it leads to protection of the plastic casing of the racks from the metal deposition, while the articles which are fastened to the racks during the fastening step are metallized.

The process step of protection of the rack is performed by treating the rack with a solution comprising a source of iodate ions. Preferably the protection of the rack is performed by treating the rack with a solution comprising iodate ions.

Treatment with iodate ions is particularly advantageous when process step B ii), in one embodiment of the invention, consists of electroless metallizing of the articles in a metallization solution.

The iodate ions are of sufficient stability in aqueous solution and are consumed only through drag-out. Generally, the effect of the protection of the rack increases with rising concentration of the iodate ions and with rising operating temperature. The protection of the rack is executed at a temperature of 20°C to 70°C, more preferably of 45°C to 55°C. Suitable sources for iodate ions are metal iodates. The metal iodates are selected from the group comprising sodium iodate, potassium iodate, magnesium iodate, calcium iodate and the hydrates thereof. The concentration of the metal iodates is between 5 g/l and 50 g/l, preferably from 15 g/l to 25 g/l. The duration of the treatment of the rack with iodate ions is between 1 and 20 minutes, preferably between 2 and 15 minutes and more preferably between 5 and 10 minutes.

The solution comprising a source for iodate ions may further comprise an acid. Inorganic acids are preferred. The inorganic acids are selected from the group comprising sulphuric acid and phosphoric acid, preferably sulphuric acid. The acid concentration is 0.02 mol/l to 2.0 mol/l, preferably 0.06 mol/l to 1.5 mol/l, more preferably 0.1 mol/l to 1.0 mol/l, based in each case on a monobasic acid. In the case of use of sulphuric acid, particular preference is given to concentrations of 5 g/l 96% sulphuric acid to 50 g/l 96% sulphuric acid, corresponding to an acid concentration of 0.1 mol/l to 1.0 mol/l based on a monobasic acid.

The described composition of the solution comprising a source for iodate ions and temperature and duration for the treatment of the rack are independent of the juncture in the process according to the invention at which the protection of the rack takes place.

Moreover, the treatment of the rack with a solution comprising a source for iodate ions shows a reservoir effect. The effect of the protection of the racks, namely the prevention of metal deposition on the racks, continues over one or more metallization cycles. A metallization cycle in the context of this invention is understood to mean a metallization process which includes optionally the fastening step, optionally the pretreatment step and process steps A) to C), but not the treatment of the rack with a solution comprising a source for iodate ions. In each metallization cycle, unmetallized articles are fastened to the racks and used to produce metallized articles. The process according to the invention comprising the treatment of the rack with a solution comprising a source for iodate ions is performed, and then one to four metallization cycles are performed. During the process according to the invention and during the metallization cycles, articles are metallized. The rack is metallized neither during the process according to the invention nor during the subsequent metallization cycles, even though the metallization cycles do not include the treatment of the rack with a solution comprising a source for iodate ions. The treatment of the rack with a solution comprising a source for iodate ions during the process according to the invention is sufficient to avoid metallization of the racks even during one to four subsequent metallization cycles.

The treatment of the rack with a solution comprising a source for iodate ions prevents the metallization of the rack, while the electrically nonconductive plastic surfaces of articles are coated with metal. The rack thus remains free of metal during the process according to the invention. With the process according to the invention, it is unnecessary to free the racks of metal again after use, since the racks are not metallized as a result of the inventive treatment with iodate ions and thus remain free of metal. Thus, after the performance of the metallization process and the removal of the metallized articles from the racks, the racks can be returned immediately back to the production cycle without further treatment and used for metallization of further articles.

No additional cleaning and etching steps are necessary for demetallization of the racks. This also reduces the expenditure for wastewater disposal. In addition, a smaller amount of chemicals is consumed. The productivity of the metallization plant is also enhanced, since, with a given number of racks available, a greater number of articles for metallization can be treated.

The process of the present invention further comprises process step B), in which a plastic surface is treated with a solution of a metal colloid or of a compound of a metal.
The metal of the metal colloid or of the metal compound is selected from the group comprising the metals of transition group I of the Periodic Table of the Elements (PTE) and transition group VIII of the PTE.

The metal of transition group VIII of the PTE is selected from the group comprising palladium, platinum, iridium, rhodium and a mixture of two or more of these metals. The metal of transition group I of the PTE is selected from the group comprising gold, silver and a mixture of these metals.

A preferred metal in the metal colloid is palladium. The metal colloid is stabilized with the protective colloid. The protective colloid is selected from the group comprising metallic protective colloids, organic protective colloids and other protective colloids. As a metallic protective colloid, preference is given to tin ions. The organic protective colloid is selected from the group comprising polyvinyl alcohol, polyvinylpyrrolidone and gelatine, preferably polyvinyl alcohol.

In a preferred embodiment of the invention, the solution of the metal colloid in process step B) is an activator solution with a palladium/tin colloid. This colloid solution is obtained from a palladium salt, a tin(II) salt and an inorganic acid. A preferred palladium salt is palladium chloride. A preferred tin(II) salt is tin(II) chloride. The inorganic acid may consist in hydrochloric acid or sulphuric acid, preferably hydrochloric acid. The colloid solution forms through reduction of the palladium chloride to palladium with the aid of the tin(II) chloride. The conversion of the palladium chloride to the colloid is complete; therefore, the colloid solution no longer contains any palladium chloride. The concentration of palladium is 5 mg/l - 100 mg/l, preferably 20 mg/l - 50 mg/l and more preferably 30 mg/l - 45 mg/l, based on Pd²⁺. The concentration of tin(II) chloride is 0.5 g/l - 10 g/l, preferably 1 g/l - 5 g/l and more preferably 2 g/l - 4 g/l, based on Sn²⁺. The concentration of hydrochloric acid is 100 ml/l - 300 ml/l (37% by weight of HCl). In addition, a palladium/tin colloid solution additionally comprises tin(IV) ions which form through oxidation of the tin(II) ions. The temperature of the colloid solution during process step B) is 20°C - 50°C and preferably 35°C - 45°C. The treatment time with the activator solution is 0.5 min - 10 min, preferably 2 min - 5 min and more preferably 3 min - 5 min.

In a further embodiment of the invention, in process step B), the solution of a compound of a metal is used in place of the metal colloid. The solution of a metal compound used is a solution comprising an acid and a metal salt. The metal in the metal salt consists in one or more of the above-listed metals of transition groups I and VIII of the PTE. The metal salt may be a palladium salt, preferably palladium chloride, palladium sulphate or palladium acetate, or a silver salt, preferably silver acetate. The acid is preferably hydrochloric acid. Alternatively, it is also possible to use a metal complex, for example a palladium complex salt, such as a salt of a palladium-aminopyridine complex. The metal compound in process step B) is present in a concentration of 40 mg/l to 80 mg/l, based on the metal. The solution of the metal compound can be employed at a temperature of 25°C to 70°C, preferably at 25°C. The treatment time with the solution of a metal compound is 0.5 min - 10 min, preferably 2 min - 6 min and more preferably 3 min - 5 min.

Between process steps A) and B), the following further process step can be performed:
A ii) treating the plastic surface in an aqueous acidic solution.

Preference is given to performing process step A ii) between process steps A i) and B). If, in the process according to the invention, process step A i) was followed by the protection of the racks, process step A ii) is more preferably performed between the protection of the racks and process step B).

The treatment of the plastic surfaces in process step A ii) is also referred to as preliminary dipping, and the aqueous acidic solution used as a preliminary dipping solution. The preliminary dipping solution has the same composition as the colloid solution in process step B), without the presence of the metal in the colloid and the protective colloid thereof. The preliminary dipping solution, in the case of use of a palladium/tin colloid solution in process step B), comprises exclusively hydrochloric acid if the colloid solution likewise comprises hydrochloric acid. For preliminary dipping, brief immersion into the preliminary dipping solution at ambient temperature is sufficient. Without rinsing the plastic surfaces, they are treated further directly with the colloid solution of process step B) after the treatment in the preliminary dipping solution.

Process step A ii) is preferably performed when process step B) involves the treatment of a plastic surface with a solution of a metal colloid. Process step A ii) can also be performed when process step B) involves the treatment of a plastic surface with a solution of a compound of a metal.

After the treatment of the plastic surfaces with the metal colloid or the metal compound in process step B), these can be rinsed.

In a further embodiment of the invention, the following further process steps are performed between process steps B) and C):
B i) treating the plastic surface in an aqueous acidic solution and
B ii) electrolessly metallizing the plastic surface in a metallizing solution.

The embodiment is shown schematically in Table 1.

**Table 1: Embodiment of plastic metallization**

| **Process step** | **Constituents** | **Time** | **Temperature** |
|---|---|---|---|
| A) Etching | 100 g/l sodium permanganate, 10 g/l 96% sulphuric acid | 5-15 min | 70°C |
| A i) Reduction | 100 g/l 96% sulphuric acid, 30 ml/l hydrogen peroxide, 30% by wt. | 1 min | 45°C |
| A ii) Preliminary dipping | Hydrochloric acid, about 10% by wt. | 1 min | 20°C |
| B) Activation | Palladium/tin colloid in hydrochloric acid solution | 3-6 min | 20-45°C |
| B i) Acceleration | Sulphuric acid (5%) | 2-6 min | 40-50°C |
| B ii) Electroless metal deposition | Chemically reductive nickel-plating or copper-plating | 6-20 min | 30-50°C |
| C) Metal deposition | For example, electrochemical copper-plating or nickel-plating | 15-70 min | 20-35°C |

These further process steps B i) and B ii) are employed when the articles are to be metallized by an electroless metallization process, i.e. a first metal layer is to be applied to the plastic surfaces by an electroless process.

If the activation in process step B) has been performed with a metal colloid, the plastic surfaces are treated in process step B i) with an accelerator solution in order to remove constituents of the colloid in the colloid solution, for example a protective colloid, from the plastic surfaces. If the colloid in the colloid solution in process step B) is a palladium/tin colloid, the accelerator solution used is preferably an aqueous solution of an acid. The acid is selected, for example, from the group comprising sulphuric acid, hydrochloric acid, citric acid and tetrafluoroboric acid. In the case of a palladium/tin colloid, the accelerator solution helps to remove the tin compounds which served as the protective colloid.

Alternatively, in process step B i), a reductor treatment is performed when, in process step B), a solution of a metal compound has been used in place of a metal colloid for the activation. The reductor solution used for this purpose then comprises, if the solution of the metal compound was a hydrochloric acid solution of palladium chloride or an acidic solution of a silver salt, hydrochloric acid and tin(II) chloride. The reductor solution may also comprise another reducing agent, such as NaH₂PO₂ or else a borane or borohydride, such as an alkali metal borane or alkaline earth metal borane or dimethylaminoborane. Preference is given to using NaH₂PO₂ in the reductor solution.

After the acceleration or treatment with the reductor solution in process step B i), the plastic surfaces can first be rinsed.

Process step B i) and optionally one or more rinse steps are followed by process step B ii) in which the plastic surfaces are metallized electrolessly. Electroless nickel-plating is accomplished, for example, using a conventional nickel bath which comprises, inter alia, nickel sulphate, a hypophosphite, for example sodium hypophosphite, as a reducing agent, and also organic complexing agents and pH adjusters (for example a buffer). The reducing agent used may likewise be dimethylaminoborane or a mixture of hypophosphite and dimethylaminoborane.

Alternatively, it is possible to use an electroless copper bath for electroless copper-plating, the electroless copper bath typically comprising a copper salt, for example copper sulphate or copper hypophosphite, and also a reducing agent, such as formaldehyde or a hypophosphite salt, for example an alkali metal or ammonium salt, or hypophosphorous acid, and additionally one or more complexing agents such as tartaric acid, and also a pH adjuster such as sodium hydroxide.

The surface thus rendered conductive can subsequently be electrolytically further metallized in order to obtain a functional or decorative surface.

Step C) of the process according to the invention is the metallization of the plastic surface with a metallization solution. The metallization in process step C) can be effected electrolytically. For electrolytic metallization, it is possible to use any desired metal deposition baths, for example for deposition of nickel, copper, silver, gold, tin, zinc, iron, lead or alloys thereof. Such deposition baths are familiar to those skilled in the art. A Watts nickel bath is typically used as a bright nickel bath, this comprising nickel sulphate, nickel chloride and boric acid, and also saccharine as an additive. An example of a composition used as a bright copper bath is one comprising copper sulphate, sulphuric acid, sodium chloride and organic sulphur compounds in which the sulphur is in a low oxidation state, for example organic sulphides or disulphides, as additives.

The effect of the metallization of the plastic surface in process step C) is that the plastic surface is coated with metal, the metal being selected from the above-listed metals for the deposition baths.

In a further embodiment of the invention, after process step C), the following further process step is performed:
C i) storage of the metallized plastic surface at elevated temperature.

As in all electroplating processes in which a nonconductor is coated by wet-chemical means with metal, the adhesion strength between metal and plastic substrate increases in the first period after the application of the metal layer. At room temperature, this process is complete after about three days. This can be accelerated considerably by storage at elevated temperature. The process is complete after about one hour at 80°C. It is assumed that the initially low adhesion strength is caused by a thin water layer which lies at the boundary between metal and nonconductive substrate and hinders the formation of electrostatic forces.

It has been found that the inventive etching with permanganate solution (process step A)) gives rise to a structure of the plastic surface which allows a greater contact area of the plastic with the metal layer than, for example, a conventional pretreatment with chromosulphuric acid. This is also the reason why higher adhesion strengths are achieved compared to the treatment with chromosulphuric acid (see Examples 2 and 3). The smoother surface, however, sometimes gives even lower initial adhesion strength directly after the metallization than in the case of use of chromosulphuric acid. Especially in the case of nickel electroplating and very particularly when the metal layers deposited have high internal stresses, or when the coefficients of thermal expansion of metal and plastic are very different and the composite is exposed to rapidly alternating temperatures, the initial adhesion strength may not be sufficient.

In that case, the treatment of the metallized plastic surfaces at elevated temperature is advantageous. Such a step may involve treating a metallized article made of ABS plastic at elevated temperature in the range from 50°C to 80°C for a period between 5 minutes and 60 minutes, preferably at a temperature of 70°C, in a water bath, in order that the water can be distributed at the metal-plastic interface in the plastic matrix. The effect of the treatment or storage of the metallized plastic surfaces at elevated temperature is that an initial, relatively low adhesion strength is enhanced further, such that, after process step C i), an adhesion strength of the metal layer applied to the plastic surface which is within the desired range of at least or greater than 0.8 N/mm is achieved.

The process according to the invention thus enables, with good process reliability and excellent adhesion strength of the subsequently applied metal layers, achievement of metallization of electrically nonconductive plastic surfaces of articles. The adhesion strength of the metal layers applied to plastic surfaces reaches values of 0.8 N/mm or higher. Thus, the adhesion strengths achieved are also well above those obtainable according to the prior art after etching of plastic surfaces with chromosulphuric acid (see Examples 2 and 3). In addition, not just planar plastic surfaces are metallized with high adhesion strength by the process according to the invention; instead, inhomogeneously shaped plastic surfaces, for example shower heads, are also provided with a homogeneous and strongly adhered metal coating.

The treatment of the plastic surfaces by the process according to the invention is preferably performed in a conventional dipping process, by dipping the articles successively into solutions in vessels, in which the respective treatment takes place. In this case, the articles may be dipped into the solutions either fastened to racks or accommodated in drums. Fastening to racks is preferred. Alternatively, the articles can also be treated in what are called conveyor plants, by lying, for example, on trays and being conveyed continuously through the plants in horizontal direction.

### Working examples

The working examples described hereinafter are intended to illustrate the invention in detail.

### Example 1: inventive example

A panel of ABS plastic (Novodur P2MC, from Ineos) of dimensions 5.2 cm x 14.9 cm x 3 mm was fastened to a stainless steel wire. The panel was dipped for ten minutes into a solution of 15% 2-(2-ethoxyethoxy)ethyl acetate and 10% butoxyethanol which had been adjusted to pH = 7 with a potassium phosphate buffer and was kept at 45°C in a thermostat (pretreatment step). Subsequently, the panel was rinsed under running water for about one minute and then introduced into a bath of 100 g/l sodium permanganate and 10 g/l 96% sulphuric acid, which was kept at 70°C (process step A)). A treatment time of ten minutes was again followed by rinsing under water for one minute, and the now dark brown panel was cleaned to remove deposited manganese dioxide in a solution of 50 g/l 96% sulphuric acid and 30 ml/l 30% hydrogen peroxide (process step A i)). After subsequent rinsing and brief dipping into a solution of 300 ml/l 36% hydrochloric acid (process step A ii)), the panel was activated in a colloidal activator based on a palladium colloid (Adhemax Aktivator PL from Atotech, 25 ppm of palladium) at 45°C for three minutes (process step B)).

After subsequent rinsing, the protective shells of the palladium particles were removed at 50°C for five minutes (Adhemax ACC1 accelerator from Atotech, process step B i)). The panel was subsequently nickel-plated at 45°C without external current for ten minutes (Adhemax LFS, from Atotech, process step B ii)), rinsed and copper-plated at 3.5 A/dm² at room temperature for 70 minutes (Cupracid HT, from Atotech, process step C)). After rinsing, the panel was stored at 80°C for 30 minutes (process step C i)). Subsequently, a knife was used to cut out a strip of the metallized plastic panel of width about 1 cm, and a tensile tester (from Instron) was used to pull the metal layer away from the plastic (ASTM B 533 1985 Reapproved 2009). An adhesion strength of 1.97 N/mm was found.

The sequence of process steps in Example 1 is summarized in Table 2.

**Table 2: Sequence of process steps in Example 1**

| **Process step** | **Chemistry** | **Time** | **Temperature** |
|---|---|---|---|
| Pretreatment | 15% 2-(2-ethoxyethoxy)ethyl acetate and 10% butoxyethanol in water, potassium phosphate buffer, pH = 7 | 10 min | 45°C |
| A) Etching | 100 g/l sodium permanganate, 10 g/l 96% sulphuric acid | 10 min | 70°C |
| A i) Reduction | 50 g/l 96% sulphuric acid, 30 ml/l hydrogen peroxide, 30% by wt. | 1 min | 45°C |
| A ii) Preliminary dipping | hydrochloric acid, 10% by weight | 1 min | 20°C |
| B) Activation | palladium colloid, 25 ppm of palladium | 3 min | 45°C |
| B i) Acceleration | sulphuric acid 5% | 5 min | 50°C |
| B ii) Electroless metal deposition | Chemically reductive nickel-plating, Adhemax LFS, from Atotech | 10 min | 45°C |
| C) Electrolytic metal deposition | Electrochemical copper-plating, Cupracid HT, from Atotech, 3.5 A/dm² | 70 min | 21°C |
| C i) Storage | --- | 30 min | 80°C |

### Example 2: Comparative experiment

Four panels of Bayblend T45 (5.2 x 14.9 x 0.3 cm, ABS/PC mixture) were treated in a 40% solution of 2-(2-ethoxyethoxy)ethyl acetate at room temperature for ten minutes. After rinsing, two panels were treated as described in Example 1 with a warm (70°C) acidic permanganate solution which comprised 100 g/l sodium permanganate and 10 g/l 96% sulphuric acid (inventive etching solution I, final concentration: 0.1 mol/l sulphuric acid). The two other panels were treated under the same conditions in an analogous permanganate solution which comprised 100 g/l 96% sulphuric acid (etching solution II with higher sulphuric acid concentration than in inventive etching solutions, final concentration: 1 mol/l sulphuric acid). After the treatment, the surface of the panels which had been treated with etching solution II was much darker than that of the panels which had been treated with etching solution I with only 10 g/l 96% sulphuric acid. Etching solution II with the higher sulphuric acid content evolved a relatively large amount of oxygen at the operating temperature thereof (70°C). After cooling etching solution II, about 50 ml of manganese dioxide slurry were found in one litre. In etching solution I, in contrast, no manganese dioxide slurry was found.

All four panels were freed reductively of the manganese dioxide, activated (25 ppm of palladium) and finally reductively nickel-plated and electrolytically copper-plated (process steps A i) to C) as in Example 1). The following adhesion strengths were found:

**Panels treated with etching solution I:**

| | | |
|---|---|---|
| Panel 1 | front side: 1.09 N/mm. | reverse side: 1.27 N/mm |
| Panel 2 | front side: 1.30 N/mm. | reverse side: 1.32 N/mm |

**Panels treated with etching solution II:**

| | | |
|---|---|---|
| Panel 3 | front side: 1.19 N/mm. | reverse side: 1.10 N/mm |
| Panel 4 | front side: 1.07 N/mm. | reverse side: 1.25 N/mm |

The adhesion strengths of the panels differ slightly from one another. In the concentration range between 10 g/l 96% sulphuric acid and 100 g/l 96% sulphuric acid, an elevated sulphuric acid content has a minor influence on the adhesion strength of the metal layer on the plastic surface. As can be inferred from the significantly higher amount of manganese dioxide formed, however, the higher sulphuric acid content of etching solution II already leads to lower stability of the etching solution.

### Example 3: Comparative experiment

Four panels of Bayblend T45 (5.2 x 14.9 x 0.3 cm, ABS/PC mixture) were treated as described in Example 2. However, the etching (process step A)) was performed under different conditions from those specified in Example 2.
Two of the four panels were treated with etching solution III (chromosulphuric acid solution from the prior art), which consisted of 380 g/l chromium(VI) oxide and 380 g/l concentrated sulphuric acid. The etching treatment was performed at 70°C for ten minutes.
The two other panels were treated with etching solution IV (alkaline permanganate solution from the prior art), which consisted of 30 g/l sodium permanganate and 20 g/l sodium hydroxide. The etching treatment was performed at 70°C for ten minutes.

For panels which had been treated with etching solution III, adhesion strengths between 0.45 N/mm and 0.70 N/mm were found, and, for panels which had been treated with etching solution IV, adhesion strengths between 0 N/mm (bubbles between metal layer and plastic surface) and 0.25 N/mm. In comparison, for panels which had been treated with the inventive etching solution (etching solution I, see Example 2), much better adhesion strengths between 1.09 N/mm and 1.32 N/mm were found.

### Example 4: Inventive example

Panels of Bayblend T45 (5.2 x 14.9 x 0.3 cm, ABS/PC mixture) were treated in a 40% solution of 2-(2-ethoxyethoxy)ethyl acetate at room temperature for ten minutes. After rinsing, as described in Example 1, the panels were treated with a warm (70°C) acidic permanganate solution which comprised 100 g/l sodium permanganate and 10 g/l 96% sulphuric acid. The treatment time in the acidic permanganate solution was varied. The panels were then freed reductively of the manganese dioxide, activated (activator with 25 ppm of palladium), reductively nickel-plated and electrolytically copper-plated (process steps A i) to C) as in Example 1). Subsequently, the adhesion strengths for the panels treated with the etching solution for different periods were determined.

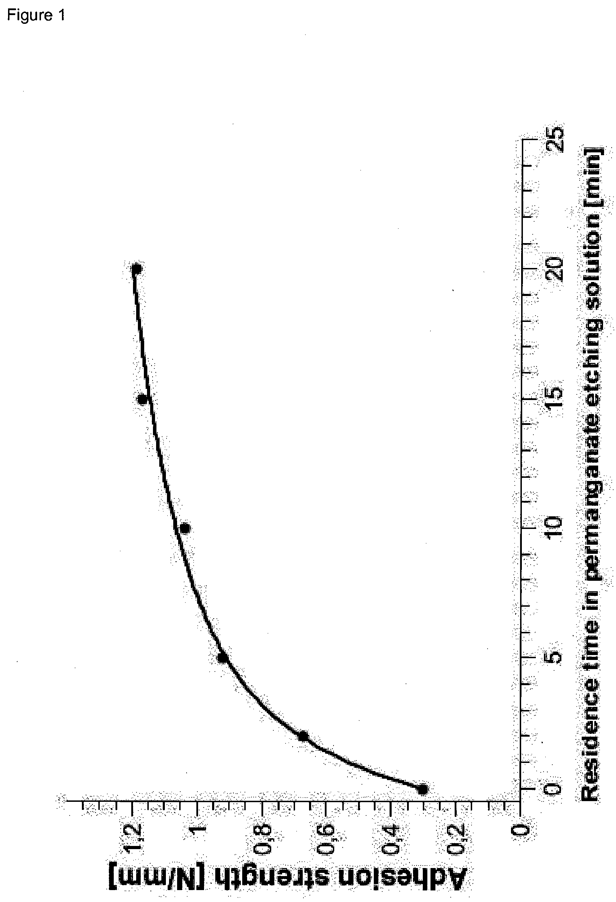

Figure 1 shows the adhesion strengths as a function of the duration of treatment in the etching solution. For panels of Bayblend T45, even after a treatment time (referred to in Figure 1 as residence time) between 5 and 10 minutes, a very good adhesion strength of 1 N/mm is achieved.

### Example 5: inventive example

Panels of size described in Example 1 of the plastics Bayblend T45 and Bayblend T65 (ABS/PC mixtures) were treated in a 20% solution of 2-(2-ethoxyethoxy)ethyl acetate at 45°C for five minutes. Thereafter, they were treated in a solution of 100 g/l sodium permanganate and 10 g/l 96% sulphuric acid at 50°C for ten minutes and, as described in Example 1, activated and then chemically reductively nickel-plated and then electrolytically copper-plated. After storage at 80°C for one hour, the adhesion strength values listed in Table 3 were found in the peel test.

**Table 3: Adhesion strengths of a copper/nickel layer on various ABS/PC mixtures**

| **Bayblend** | **Adhesion strengths [N/mm]** | | |
|---|---|---|---|
| | **Front** | **Reverse** | **Mean** |
| T65 | 0.95 | 1.00 | 0.97 |
| T45 | 1.33 | 1.50 | 1.42 |

### Example 6:

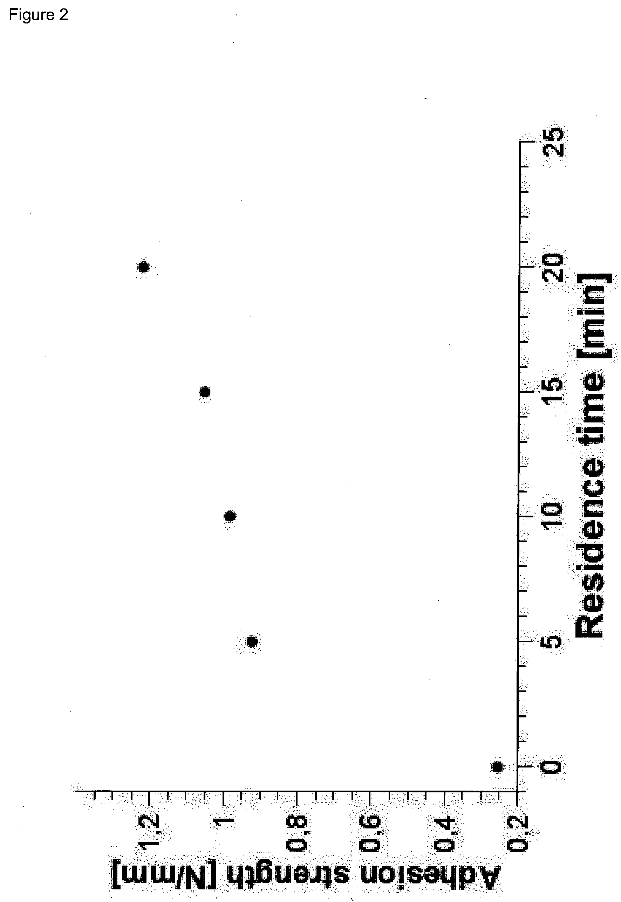

Panels of Bayblend T45 were treated in a 15% solution of 2-(2-ethoxyethoxy)ethyl acetate and 10% butoxyethanol at 45°C for different periods of time. Subsequently, the panels were etched in acidic permanganate solution for five minutes, activated and copper-plated, as described in Example 1. After storage at 80°C for one hour, the adhesion strengths were determined in the peel test.
The adhesion strengths of the metal layer are shown in Figure 2 and summarized in Table 4. The residence time of the plastic surfaces in the solution of the glycol compounds (pretreatment step) has an influence on the adhesion strength of the metal layers applied. Without treatment with glycol compounds (residence time 0 min in Figure 2), only a adhesion strength of 0.25 N/mm was obtained. After treatment with glycol compounds for only 5 minutes, in contrast, a good adhesion strength of 0.92 N/mm was already achieved, and this rises further with longer treatment time.

**Table 4: Adhesion strength of a metal layer after treatment of the ABS/PC article with glycol compounds for different periods.**

| Residence time [min] | Adhesion strength [N/mm] |
|---|---|
| 0 | 0.25 |
| 5 | 0.92 |
| 10 | 0.98 |
| 15 | 1.05 |
| 20 | 1.22 |

### Example 7:

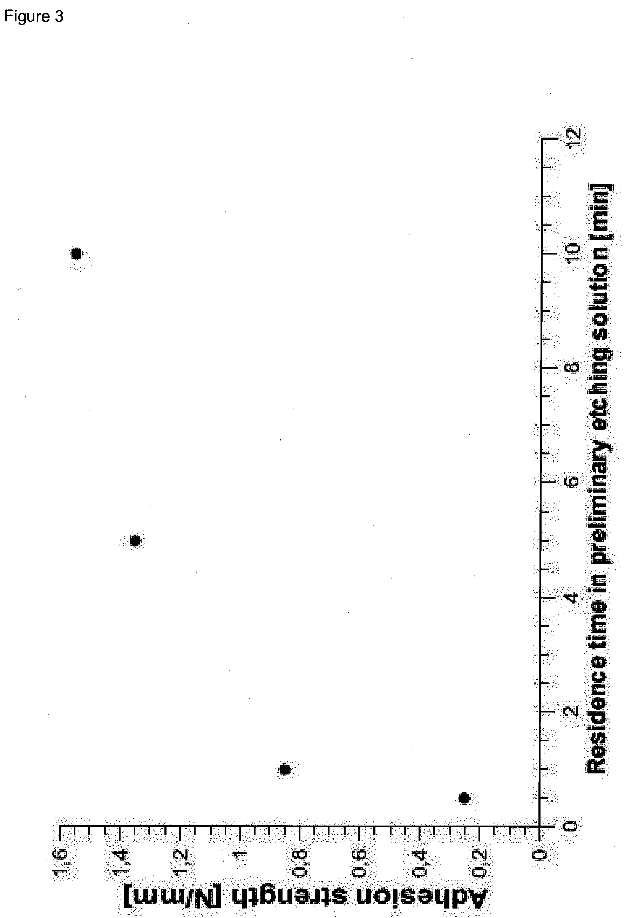

Panels of ABS plastic (Novodur P2MC) were, as described in Example 6, treated with a 15% solution of 2-(2-ethoxyethoxy)ethyl acetate and 10% butoxyethanol for different periods of time and subjected to the further metallization process, and the adhesion strengths of the metal layer applied were determined.
The adhesion strengths of the metal layer as a function of the treatment time with the solution of the glycol compounds are shown in Figure 3 and summarized in Table 5. Here too, the influence of the treatment time (referred to in Figure 3 as residence time in the preliminary etching solution) on the adhesion strength of the metal layers applied is clearly evident. Without treatment with glycol compounds (residence time 0 min in Figure 3), only a adhesion strength of 0.25 N/mm was obtained. After treatment with glycol compounds for only 5 minutes, in contrast, a very good adhesion strength of 1.35 N/mm was already achieved, and this rises further with longer treatment time.

**Table 5: Adhesion strength of a metal layer after treatment of the ABS article with glycol compounds for different periods.**

| Residence time [min] | Adhesion strength [N/mm] |
|---|---|
| 0.5 | 0.25 |
| 1.0 | 0.85 |
| 5.0 | 1.35 |
| 10.0 | 1.55 |

### Example 8: Comparative Example

A panel of Bayblend T45PG (10 cm x 5 cm, ABS/PC mixture) was pretreated in a 40% solution of 2-(2-ethoxyethoxy) ethyl acetate which had been adjusted to pH = 7 with a potassium phosphate buffer at 25°C for 7 minutes (pretreatment step). Subsequently, the panel was rinsed under running water for about one minute.
Etching treatment: The pretreated panel was etched firstly with a solution of 10 g/l 96% H₂SO₄ containing no permanganate (etching solution V) which had been heated to 70°C for 10 minutes. Afterwards the panel was etched with the alkaline permanganate solution (30 g/l NaMnO₄ and 20 g/l NaOH, etching solution IV) which had been kept at 50°C for 10 minutes.
Subsequently, the panel was treated with reduction solution composed of 25 ml/l 96% sulphuric acid and 30 ml/l 30% hydrogen peroxide at 45°C to remove the manganese dioxide from the panel (process step A i)). After subsequent rinsing the panel was briefly preliminaryly dipped into a solution of 300 ml/l 36% hydrochloric acid (process step A ii)). Subsequently, the panel was activated in a colloid activator based on a palladium colloid (Adhemax Aktivator PL from Atotech, 50 ppm of palladium) at 35°C for 5 minutes (process step B)). Thereafter, the panel was rinsed and then the protective shells of the palladium particles were removed at 50°C for 5 minutes (Adhemax ACC1 accelerator from Atotech, process step B i)).
The panel was subsequently nickel-plated without external current for 10 minutes (Adhemax LFS, from Atotech, process step B ii)) at 40°C. Thereafter, the panel was rinsed and copper-plated at 3.5 A/dm² at room temperature for one hour (Cupracid HT, from Atotech, process step C)). After rinsing, the panel was stored at 80°C for one hour (process step C i)).

The adhesion strength of the deposited metal layers was determined as described in Example 1. Adhesion strength was measured to be: 0.10 N/mm; 0.12 N/mm; 0.11 N/mm; and 0.11 N/mm, giving a mean of 0.11 N/mm.

The sequence of process steps in Example 8 is summarized in Table 6.

**Table 6: Sequence of process steps in Example 8**

| **Process step** | **Chemistry** | **Time** | **Temperature** |
|---|---|---|---|
| Pretreatment | 40% 2-(2-ethoxyethoxy) ethyl acetate in water, potassium phosphate buffer, pH=7 | 7 min | 25°C |
| A) Etching: | 10 g/l 96% H₂SO₄ and | 10 min | 70°C |
| | 30 g/l NaMnO₄ and 20 g/l NaOH | 10min | 50°C |
| A iii) Reduction | 25 ml/l 96% sulphuric acid, 30 ml/l hydrogen peroxide, 30% by wt. | 1 min | 45°C |
| A iv) Preliminary dipping | 300 ml/l 36% hydrochloric acid | 1 min | 20°C |
| B) Activation | Palladium colloid, 50 ppm of palladium | 5 min | 35°C |
| B i) Acceleration | Sulphuric acid 5% | 5 min | 50°C |
| B ii) Electroless metal deposition | Chemically reductive nickel-plating, Adhemax LFS, from Atotech | 10 min | 40°C |
| C) Electrolytic metal deposition | Electrochemical copper-plating, Cupracid HT, from Atotech, 3.5 A/dm² | 60 min | 21°C |
| C i) Storage | --- | 60 min | 80°C |

### Example 9: Comparative Example

An ABS panel (Novodur P2MC, moulded 2012-03-23, 5cm x 10cm) was pre-treated at 45°C for ten minutes in a solution of 15 vol% 2-(2-ethoxyethoxy) ethyl acetate and 10% ethyleneglycol monobutylether in water.
The panel was then rinsed and afterwards etched in a solution of KMnO₄ 65 g/l, NaOH 50 g/l and NaOCl 10 g/l for 10 minutes at 65 °C. The surface of the panel got irregular with bubbles.

The panel was then reduced in a solution of 30ml/l 30% hydrogen peroxide and 25% sulphuric acid (45°C) within two minutes. The surface of the panel was hydrophobic.
Afterwards the panel was activated in a colloidal activator (Adhemax Aktivator PL from Atotech, 50mg/l palladium, 35°C) for five minutes, rinsed, accelerated in 5% sulphuric acid at 50°C and electrolessly nickel plated (Adhemax Ni LFS from Atotech, 45°C, ten minutes). After this step, the panel was electrolytically copper-plated (Cupracid HT from Atotech, 3.5A/dm², ambient temperature, 60 minutes). The plated panel was allowed to rest one hour at 75°C.
Adhesion strength was too low for reading.

### Example 10: Comparative Example

An ABS panel of 5cm x 10cm (Novodur P2MC, moulded 2012-03-23) was immersed in concentrated nitric acid (65% by weight) at ambient temperature (23°C) for two minutes, was then rinsed with de-ionized water and dried using compressed air blowing. The surface of the ABS got matte.

Afterwards the panel was treated with concentrated sulphuric acid (96% by weight) for 30 seconds at ambient temperature and was then rinsed with de-ionized water. Then the panel was contacted with an aqueous solution of 1.2 N sodium hydroxide and 0.1 N sodium permanganate, for 5 minutes at 75°C. In sulphuric acid only the surface which had been in contact with the nitric acid turned brown and later was attacked by the alkaline permanganate solution.

The panel was then reduced, activated in a colloidal activator, rinsed, accelerated, electrolessly nickel plated, electrolytically copper-plated, and allowed to rest at 75°C as described in Example 9.

During electroless nickel deposition a lot of stable foam was evolved for unknown reason, and the plastic surface was not properly nickel coated because of the foam. Blisters occuring during acid copper plating indicated complete lack of adhesion.

## Claims

1. Process for metallizing electrically nonconductive plastic surfaces of articles, comprising the process steps of:
A) etching the plastic surface with an etching solution;
B) treating the plastic surface with a solution of a metal colloid or of a compound of a metal, the metal being selected from the metals of transition group I of the Periodic Table of the Elements and transition group VIII of the Periodic Table of the Elements, and
C) metallizing the plastic surface with a metallizing solution;
**characterized in that** the etching solution comprises a source for permanganate ions, and an acid in a concentration of 0.02 - 0.6 mol/l based on a monobasic acid.

2. Process according to Claim 1, **characterized in that** process step A) is preceded by performance of the following further process step:
pretreatment step: treating the plastic surface in an aqueous solution comprising at least one glycol compound.

3. Process according to Claim 2, **characterized in that** the at least one glycol compound is selected from compounds of the general formula (I) 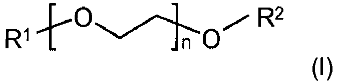 wherein
n is an integer from 1 to 4; and
R¹ and R² are each independently -H, -CH₃, -CH₂-CH₃, -CH₂CH₂CH₃, -CH(CH₃)-CH₃, -CH₂-CH₂-CH₂-CH₃, -CH(Ch₃)-CH₂-CH₃, -CH₂-CH(CH₃)-CH₃, -CH₂-CH₂-CH₂-CH₂-CH₃, -CH(CH₃)-CH₂-CH₂-CH₃, -CH₂₋CH(CH₃)-CH₂-CH₃, -CH₂-CH₂-CH(CH₃)-CH₃, -CH(CH₂-CH₃)-CH₂-CH₃, -CH₂-CH(CH₂-CH₃)-CH₃, -CO-CH₃, -CO-CH₂-CH₃, -CO-CH₂-CH₂-CH₃, -CO-CH(CH₃)-CH₃, -CO-CH(CH₃)-CH₂-CH₃, -CO-CH₂-CH(CH₃)-CH₃, -CO-CH₂-CH₂-CH₂-CH₃.

4. Process according to any of the preceding claims, **characterized in that** the source for permanganate ions in the etching solution in process step A) is selected from alkali metal permanganates.

5. Process according to claim 4, **characterized in that** the alkali metal permanganates are selected from the group comprising potassium permanganate and sodium permanganate.

6. Process according to any of the preceding claims, **characterized in that** the source for permanganate ions is present in the etching solution in process step A) in a concentration between 30 g/l - 250 g/l.

7. Process according to any of the preceding claims, **characterized in that** the acid comprised in the etching solution in process step A) is an inorganic acid.

8. Process according to claim 7, **characterized in that** the inorganic acid in the etching solution in process step A) is selected from the group comprising sulphuric acid, nitric acid and phosphoric acid.

9. Process according to any of the preceding claims, **characterized in that** the plastic surface has been manufactured from at least one electrically nonconductive plastic and the at least one electrically nonconductive plastic is selected from the group comprising an acrylonitrile-butadiene-styrene copolymer, a polyamide, a polycarbonate and a mixture of an acrylonitrile-butadiene-styrene copolymer with at least one further polymer.

10. Process according to any of the preceding claims, **characterized in that** the following further process step is performed between process steps A) and B):
A i) treating the plastic surface in a solution comprising a reducing agent for manganese dioxide.

11. Process according to Claim 10, **characterized in that** the reducing agent for manganese dioxide is selected from the group comprising hydroxylammonium sulphate, hydroxylammonium chloride and hydrogen peroxide.

12. Process according to any of the preceding claims, **characterized in that** the following further process steps are performed between process steps B) and C):
B i) treating the plastic surface in an aqueous acidic solution and
B ii) electrolessly metallizing the plastic surface in a metallizing solution.

## Patentansprüche

1. Verfahren zum Metallisieren von elektrisch nichtleitenden Kunststoffoberflächen von Gegenständen, umfassend die Verfahrensschritte:
A) Beizen der Kunststoffoberfläche mit einer Beizlösung,
B) Behandeln der Kunststoffoberfläche mit einer Lösung eines Metall-Kolloids oder einer Verbindung eines Metalls, wobei das Metall ausgewählt ist aus den Metallen der I. Nebengruppe des Periodensystems der Elemente und der VIII. Nebengruppe des Periodensystems der Elemente, und
C) Metallisieren der Kunststoffoberfläche mit einer Metallisierungslösung;
**dadurch gekennzeichnet, dass** die Beizlösung eine Quelle für Permanganationen enthält und eine Säure in einer Konzentration von 0,02 - 0,6 mol/l bezogen auf eine einbasige Säure.

2. Verfahren nach Anspruch 1, **dadurch gekennzeichnet, dass** vor Verfahrensschritt A) folgender weiterer Verfahrensschritt durchgeführt wird:
Vorbehandlungsschritt: Behandeln der Kunststoffoberfläche in einer wässrigen Lösung enthaltend mindestens eine Glykolverbindung.

3. Verfahren nach Anspruch 2, **dadurch gekennzeichnet, dass** die mindestens eine Glykolverbindung ausgewählt wird aus Verbindungen gemäß allgemeiner Formel (I) 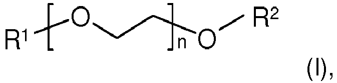 worin
n eine ganze Zahl zwischen 1 und 4 bedeutet; und
R¹ und R² unabhängig voneinander bedeuten -H, -CH₃, -CH₂-CH₃, -CH₂-CH₂-CH₃, -CH(CH₃)-CH₃, -CH₂-CH₂-CH₂-CH₃, -CH(CH₃)-CH₂-CH₃, -CH₂-CH(CH₃)-CH₃, -CH₂-CH₂-CH₂-CH₂-CH₃, -CH(CH₃)-CH₂-CH₂-CH₃, -CH₂-CH(CH₃)-CH₂-CH₃, -CH₂-CH₂-CH(CH₃)-CH₃, -CH(CH₂-CH₃)-CH₂-CH₃, -CH₂-CH(CH₂-CH₃)-CH₃, -CO-CH₃, -CO-CH₂-CH₃, -CO-CH₂-CH₂-CH₃, -CO-CH(CH₃)-CH₃, -CO-CH(CH₃)-CH₂-CH₃, -CO-CH₂-CH(CH₃)-CH₃, -CO-CH₂-CH₂-CH₂-CH₃.

4. Verfahren nach einem der vorstehenden Ansprüche, **dadurch gekennzeichnet, dass** die Quelle für Permanganationen in der Beizlösung gemäß Verfahrensschritt A) ausgewählt wird aus Alkalimetall-Permanganaten.

5. Verfahren nach Anspruch 4, **dadurch gekennzeichnet, dass** die Alkalimetall-Permanganate ausgewählt werden aus der Gruppe enthaltend Kaliumpermanganat und Natriumpermanganat.

6. Verfahren nach einem der vorstehenden Ansprüche, **dadurch gekennzeichnet, dass** die Quelle für Permanganationen in der Beizlösung gemäß Verfahrensschritt A) in einer Konzentration zwischen 30 g/l - 250 g/l vorliegt.

7. Verfahren nach einem der vorstehenden Ansprüche, **dadurch gekennzeichnet, dass** die Säure in der Beizlösung gemäß Verfahrensschritt A) eine anorganische Säure ist.

8. Verfahren nach Anspruch 7, **dadurch gekennzeichnet, dass** die anorganische Säure in der Beizlösung gemäß Verfahrensschritt A) ausgewählt wird aus der Gruppe enthaltend Schwefelsäure, Salpetersäure und Phosphorsäure.

9. Verfahren nach einem der vorstehenden Ansprüche, **dadurch gekennzeichnet, dass** die Kunststoffoberfläche aus mindestens einem elektrisch nichtleitenden Kunststoff gefertigt ist und der mindestens eine elektrisch nichtleitende Kunststoff ausgewählt ist aus der Gruppe enthaltend ein Acrylnitril-Butadien-Styrol-Copolymer, ein Polyamid, ein Polycarbonat und eine Mischung eines Acrylnitril-Butadien-Styrol-Copolymers mit mindestens einem weiteren Polymer.

10. Verfahren nach einem der vorstehenden Ansprüche, **dadurch gekennzeichnet, dass** zwischen den Verfahrensschritten A) und B) folgender weiterer Verfahrensschritt durchgeführt wird:
A i) Behandeln der Kunststoffoberfläche in einer Lösung enthaltend ein Reduktionsmittel für Mangandioxid.

11. Verfahren nach Anspruch 10, **dadurch gekennzeichnet, dass** das Reduktionsmittel für Mangandioxid ausgewählt wird aus der Gruppe enthaltend Hydroxylammoniumsulfat, Hydroxylammoniumchlorid und Wasserstoffperoxid.

12. Verfahren nach einem der vorstehenden Ansprüche, **dadurch gekennzeichnet, dass** zwischen den Verfahrensschritten B) und C) folgende weitere Verfahrensschritte durchgeführt werden:
B i) Behandeln der Kunststoffoberfläche in einer wässrigen sauren Lösung und
B ii) Stromloses Metallisieren der Kunststoffoberfläche in einer Metallisierungslösung.

## Revendications

1. Procédé de métallisation de surfaces en plastique électriquement non conductrices d'articles, comprenant les étapes de procédé consistant à :
A) graver la surface en plastique avec une solution de gravure ;
B) traiter la surface en plastique avec une solution d'un colloïde métallique ou d'un composé d'un métal, le métal étant choisi parmi les métaux du groupe de transition I du tableau périodique des éléments et du groupe de transition VIII du tableau périodique des éléments ; et
C) métalliser la surface en plastique avec une solution de métallisation ;
**caractérisé en ce que** la solution de gravure comprend une source d'ions permanganate, et un acide à une concentration de 0,02-0,6 mol/l sur la base d'un acide monobasique.

2. Procédé selon la revendication 1, **caractérisé en ce que** l'étape de procédé A) est précédée de la réalisation de l'étape de procédé supplémentaire suivante :
étape de prétraitement : traiter la surface en plastique dans une solution aqueuse comprenant au moins un composé glycolique.

3. Procédé selon la revendication 2, **caractérisé en ce que** l'au moins un composé glycolique est choisi parmi les composés de la formule générale (I) 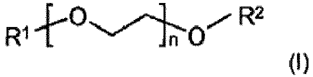 dans laquelle
**n** est un entier de 1 à 4 ; et
**R¹** et **R²** représentent chacun indépendamment -H, -CH₃, -CH₂-CH₃, -CH₂-CH₂-CH₃, -CH(CH₃)-CH₃, -CH₂-CH₂-CH₂-CH₃, -CH (CH₃)-CH₂-CH₃, -CH₂-CH(CH₃)-CH₃, -CH₂-CH₂-CH₂-CH₂-CH₃, -CH(CH₃)-CH₂-CH₂-CH₃, -CH₂-CH(CH₃)-CH₂-CH₃, -CH₂-CH₂-CH(CH₃)-CH₃, -CH(CH₂CH₃)-CH₂CH₃, -CH₂-CH(CH₂-CH₃)-CH₃, -CO-CH₃, -CO-CH₂-CH₃, -CO-CH₂-CH₂-CH₃, -CO-CH(CH₃)-CH₃, -CO-CH(CH₃)-CH₂-CH₃, -CO-CH₂-CH(CH₃)-CH₃, -CO-CH₂-CH₂-CH₂-CH₃.

4. Procédé selon l'une quelconque des revendications précédentes, **caractérisé en ce que** la source d'ions permanganate dans la solution de gravure à l'étape de procédé A) est choisie parmi les permanganates de métaux alcalins.

5. Procédé selon la revendication 4, **caractérisé en ce que** les permanganates de métaux alcalins sont choisis dans le groupe comprenant le permanganate de potassium et le permanganate de sodium.

6. Procédé selon l'une quelconque des revendications précédentes, **caractérisé en ce que** la source d'ions permanganate est présente dans la solution de gravure à l'étape de procédé A) à une concentration comprise entre 30 g/l et 250 g/l.

7. Procédé selon l'une quelconque des revendications précédentes, **caractérisé en ce que** l'acide contenu dans la solution de gravure à l'étape de procédé A) est un acide inorganique.

8. Procédé selon la revendication 7, **caractérisé en ce que** l'acide inorganique dans la solution de gravure à l'étape de procédé A) est choisi dans le groupe comprenant l'acide sulfurique, l'acide nitrique et l'acide phosphorique.

9. Procédé selon l'une quelconque des revendications précédentes, **caractérisé en ce que** la surface en plastique a été fabriquée à partir d'au moins un plastique électriquement non conducteur et l'au moins un plastique électriquement non conducteur est choisi dans le groupe comprenant un copolymère acrylonitrile-butadiène-styrène, un polyamide, un polycarbonate et un mélange d'un copolymère acrylonitrile-butadiène-styrène avec au moins un autre polymère.

10. Procédé selon l'une quelconque des revendications précédentes, **caractérisé en ce que** l'étape de procédé supplémentaire suivante est effectuée entre les étapes de procédé A) et B) :
Ai) traiter la surface en plastique dans une solution comprenant un réducteur du dioxyde de manganèse.

11. Procédé selon la revendication 10, **caractérisé en ce que** le réducteur du dioxyde de manganèse est choisi dans le groupe comprenant le sulfate d'hydroxylammonium, le chlorure d'hydroxylammonium et le peroxyde d'hydrogène.

12. Procédé selon l'une quelconque des revendications précédentes, **caractérisé en ce que** les étapes de procédé supplémentaires suivantes sont effectuées entre les étapes de procédé B) et C) :
Bi) traiter la surface en plastique dans une solution aqueuse acide et
Bii) métalliser sans courant la surface en plastique dans une solution de métallisation.
